# EUROPEAN PATENT APPLICATION

(11) **EP 4 391 759 A1**
(43) Date of publication of application: **26.06.2024**
(21) Application number: 22214827.2
(22) Date of filing: 20.12.2022
(51) Int. Cl.: H10B 10/00, H01L 27/06, H01L 29/775

(54) **A STACKED SRAM CELL WITH A DUAL-SIDE INTERCONNECT STRUCTURE**

(71) Applicant: Imec VZW, 3001 Leuven (BE); Katholieke Universiteit Leuven KU Leuven Research & Development, 3000 Leuven (BE)
(72) Inventor: Liu, Hsiao-Hsuan, 3001 Leuven (BE); Salahuddin, Shairfe Muhammad, 3010 Kessel Lo (BE); Chan, Boon Teik, 3012 Wilsele (BE); Subramanian, Sujith, 3000 Leuven (BE)
(74) Representative: Roth, Sebastian

(57) **Abstract**

The present disclosure relates to static random access memory (SRAM). In particular, the disclosure provides a stacked SRAM cell, and a method for fabricating the stacked SRAM cell. The stacked SRAM cell comprises two first transistor structures and two second transistor structures, which form a pair of cross-coupled inverters, an comprises one or two pass gate (PG) transistor structures. Further, the stacked SRAM cell comprises a first power rail and/or a second power rail arranged above the transistor structures, wherein the first power rail is connected by respective first vias to the first transistor structures from above, and/or the second power rail is connected by respective second vias to the second transistor structures from above. The SRAM cell also comprises one or two bit lines arranged below the PG transistor structures. Each bit line is connected by a respective third via to one PG transistor structure from below.

## Description

### TECHNICAL FIELD

The present disclosure relates to static random access memory (SRAM). In particular, the disclosure provides a stacked SRAM cell, which is based on a complimentary field effect transistor (CFET), and a method for fabricating the stacked SRAM cell. The stacked SRAM cell also comprises an interconnect structure, which is fabricated by dual-side back end of line (BEOL) processing.

### BACKGROUND OF THE INVENTION

SRAM is a form of semiconductor memory that is widely used in electronics, microprocessor, and general computing applications. A SRAM device can store data in a static fashion, and does not need to be dynamically updated like other types of memory devices.

An SRAM device comprises a plurality of SRAM cells, wherein each SRAM cell is configured to store one bit of data. A typical SRAM cell has four transistors used for storing the bit, wherein the four transistors are configured as two cross-coupled inverters. The SRAM cell has two stable states, which determine the logical "0" and "1" states of the bit. In addition to the four transistors used for storing the bit, the typical SRAM cell includes two further transistors (called pass gate (PG) transistors), which are used to control the access to the four transistors during a bit read or a bit write operation.

Nowadays, many methods of fabricating SRAM cells aim at reducing the cell area of the SRAM cell, and increasing its performance. For instance, stacked SRAM cells, in which the transistors of the SRAM cell are arranged in multiple tiers (or levels) stacked one above the other, could lead to a reduced cell area.

As an example, stacked SRAM cells could be based on CFET, wherein NMOS transistors and PMOS transistors are processed in a stacked manner, and are cross-coupled to form the two cross-coupled inverters.

However, the stacking of the transistors of the SRAM cell also leads to drawbacks, in particular, regarding the design of the interconnect structure. The transistors of the stacked SRAM cell can be connected by the use of vias, for example, to word line and bit line. Due to the stacked arrangement, these vias become relatively long, however, which leads to high via capacitances. In fact, via capacitances of a stacked SRAM cell may occupy a large percentage of the total BEOL capacitance. Another drawback is that the widths of the word line and bit line are limited when using such a stacked SRAM cell.

As a consequence, it becomes difficult to further scale down the cell area of the SRAM cell, and to further improve the performance.

### SUMMARY OF THE INVENTION

In view of the above, this disclosure intends to provide an improved SRAM cell. An objective is to provide an SRAM cell with a compact cell area, and with small via capacitances. Another objective is to enable wide word lines and bit lines. To this end, an objective in particular is to design an improved interconnect structure suitable for a stacked SRAM cell. Another objective is to provide a method that is efficient in fabricating the stacked SRAM cell and the interconnect structure.

These and other objectives are achieved by the solutions described in the independent claims. Advantageous implementations are described in the dependent claims.

A first aspect of this disclosure provides a stacked static random access memory, SRAM, cell comprising: two first transistor structures; two second transistor structures wherein the first transistor structures and the second transistor structures form a pair of cross-coupled inverters; one or two pass gate (PG) transistor structures; one or more first power rails and/or one or more second power rails arranged above the first and the second transistor structures, wherein the one or more first power rails are connected by respective first vias to at least one of the first transistor structures from above, and/or the one or more second power rails are connected by respective second vias to at least one of the second transistor structures from above; and one or two bit lines arranged below the PG transistor structures, wherein each bit line is connected by a respective third via to one PG transistor structure from below.

The SRAM cell of the first aspect may be a five transistor structure (5T) or a six transistor structure (6T) SRAM cell. However, the SRAM cell could also comprise additional transistor structures, and could in this case, for example, be a 7T, 8T, 9T, or 10T SRAM cell.

A transistor structure in this disclosure may be or may comprise a transistor, like a FET, or maybe or may comprise a more complex semiconductor-based structure, which functions like a transistor. For instance, this semiconductor-based structure maybe a nanosheet structure, a fin structure, or a forksheet structure, for example, provided with a gate-all-around. With a gate all-around, the gate structure may be a wrap-around gate structure, completely enclosing the channel layer of the transistor structure, or may be of a so-called forksheet type, in which the gate structure wraps around only a part of the channel layer of the transistor structure. In the latter case, the dielectric wall may form a part of the forksheet wall separating the channel layers.

Notably, in this disclosure the terms "below" and "above", "bottom" and "top", or similar terms are to be interpreted relative to each other. In particular, these terms describe opposite sides of the SRAM cell, or opposite side of any element of the SRAM cell. The terms may describe a relationship of elements (e.g., transistor structures, lines, rails, etc.) of the stacked SRAM cell along the direction of stacking. The direction of stacking may align with the arrangement of multiple tiers of the SRAM cell. That is, two or more tiers arranged above each other mean that the tiers are arranged one after the other along a certain direction (the stacking direction). The above terms could also be swapped. For instance, in the SRAM cell of the first aspect, the one or two bit lines are placed at the bottom of the SRAM cell, while the power rails are placed at the top of the SRAM cell. However, the one or two bit lines could also be considered being at the top of the SRAM cell, and the power rails could be considered being at the bottom of the stacked SRAM cell.

In an implementation of the SRAM cell, a word line is arranged below the PG transistor structures, wherein the word line is connected by one or two respective fourth vias to the one or two PG transistor structures from below.

The above-described stacked SRAM cell of the first aspect and its implementation form has a smaller cell area than, for example, a conventional planar SRAM cell. The SRAM cell of the first aspect further allows placing the bit line(s) on the opposite side of the transistor structures (i.e., bottom side vs. top side) than the one or more power rails. In addition, also the word line may be placed on the opposite side of the transistor structures than the one or more power rails. This means that metal layers of the BEOL can be arranged on both sides, the bottom side and the top side of the SRAM cell, which allows reducing the lengths of the third and/or fourth vias, and potentially the lengths of the first and/or second vias. Thus, the overall BEOL capacitance of the SRAM cell, and of an SRAM device including the SRAM cell of the first aspect, may be lowered. In addition, the dual-side BEOL processing also allows making the bit lines and the word line wider, which decreases their resistances.

As a consequence of the above, scaling down the cell area is facilitated with the stacked SRAM cell of the first aspect, and the performance of the SRAM cell and the SRAM device can be improved.

In an implementation of the SRAM cell, the SRAM cell comprises a plurality of stacked tiers, wherein at least one of the first, the second, or the PG transistor structures is formed in each of the tiers.

Each tier may be a level or layer of the SRAM cell, in which one or more elements of the SRAM cell are processed, before the next tier (one above or below) is processed. As mentioned above, the tiers are arranged along the stacking direction of the stacked SRAM cell. As an example, the SRAM cell of the first aspect may comprise two, three, or six tiers. Stacking the transistor structures in multiple tiers allows reducing the cell area of the SRAM cell.

In an implementation of the SRAM cell, the first transistor structures are formed in a first tier of the SRAM cell; the second transistor structures are formed in a second tier of the SRAM cell, the second tier being arranged above the first tier; the one or two PG structures are formed in the first tier or in a third tier of the SRAM cell, the third tier being arranged below the first tier; and the first and the second power rails are arranged above the second tier, wherein the first power rails are connected by respective first vias to the first transistor structures from above, and the second power rails are connected by respective second vias to the second transistor structures from above.

This implementation describes a two-tier or a three-tier SRAM cell, respectively, for reducing the cell area. An interconnect structure for the SRAM cell is provided, which leads to lower via capacitances.

The transistor structures of the two-tier or three-tier SRAM cell may also be arranged differently. For example, in an implementation form, the second transistors structures may be formed in the first tier, while the first transistor structures are formed in the second tier. The PG transistor structures may in this case be formed in the third tier, or together with the second transistor structures in the first tier.

In an implementation of the SRAM cell, a length of each third via is smaller than a height of the second tier; and/or a length of each fourth via is smaller than a height of the second tier.

In an implementation of the SRAM cell, a first PG transistor structure is formed in a first tier of the SRAM cell; the two first transistor structures and the two second transistor structures are formed, respectively, in a second tier, a third tier, a fourth tier, and a fifth tier of the SRAM cell, the second tier being arranged above the first tier, the third tier being arranged above the second tier, the fourth tier being arranged above the third tier, and the fifth tier being arranged above the fourth tier; a second PG transistor structure is formed in a sixth tier of the SRAM cell, the sixth tier being arranged above the fifth tier; a first bit line is arranged below the first tier and is connected by one third via to the first PG transistor structure from below; and a second bit line is arranged above the sixth tier and is connected by a fifth via to the second PG transistor structure from above.

This implementation describes a six-tier SRAM cell for reducing the cell area. The first transistor structures and the second transistor structures may be arranged in any order, e.g. interleaved or non-interleaved, in respectively the second to fifth tiers.

In an implementation of the SRAM cell, the transistor structures are nanosheet transistor structures, or forksheet transistor structures, or fin transistor structures.

In an implementation of the SRAM cell, the first transistor structures and the one or two PG transistor structures are PMOS transistor structures, and the second transistor structures are NMOS transistor structures.

In an implementation of the SRAM cell the first transistor structures are pull-up (PU) transistor structures, and the second transistor structures are pull-down (PD) transistor structures of the SRAM cell.

In an implementation of the SRAM cell, the one or more first power rails are configured to provide a supply voltage (VDD), and the one or more second power rails are configured to provide a ground voltage (VSS).

In an implementation of the SRAM cell, the first transistor structures and the one or two PG transistor structures are NMOS transistor structures, and the second transistor structures are PMOS transistor structures.

In an implementation of the SRAM cell, the first transistor structures are PD transistor structures, and the second transistor structures are PU transistor structures.

In an implementation of the SRAM cell, the one or more first power rails are configured to provide a ground voltage (VSS), and the one or more second power rails are configured to provide a supply voltage (VDD).

A second aspect of this disclosure provides a method for processing a stacked static random access memory, SRAM, cell, the method comprising: processing one or two pass gate, PG, transistor structures on a substrate; processing two first transistor structures on the substrate or above the PG transistor structures; processing two second transistor structures on the substrate or above the PG transistor structures; forming a pair of cross-coupled inverters from the first transistor structures and the second transistor structures; processing one or more first power rails and/or one or more second power rails above the second transistor structures; processing respective first vias to connect the one or more first power rails to at least one of the first transistor structures from above, and/or respective second vias to connect the one or more second power rails to at least one of the second transistor structures from above; removing the substrate; processing one or two bit lines below the one or two PG transistor structures; and processing respective one or two third vias to connect each bit line respectively to one PG transistor structure from below.

The method of the second aspect enables the fabrication of the stacked SRAM cell of the first aspect and any implementation form thereof, including the interconnect structure. Accordingly, the method of the second aspect may achieve the same advantages as described above for the stacked SRAM cell of the first aspect.

The method of the second aspect may implement the dual-side BEOL processing. For instance, the one or more power rails may be processed on the front side of the stack. Then, after removing the substrate, the stack may be flipped (i.e., turned around), and the one or two bit lines may be processed on the former back side (front side after turning). In this way, BEOL layers and structures can be processed on both sides of the transistor structures of the SRAM cell, in order to obtain the interconnect structure proposed in this disclosure, and thus the above-explained benefits of the reduced via capacitances and reduced memory line resistances.

In an implementation of the method, the first transistor structures are processed from first channel layers, and the second transistor structures are processed from second channel layers; and wherein the second channel layers are stacked above the first channel layers and/or at least one of the first channel layers and the second channel layers is formed on the substrate.

In an implementation of the method, removing the substrate comprises thinning the substrate from the backside, to expose the channel layers formed on the substrate.

In an implementation of the method, the transistor structures are nanosheet transistor structures or fin transistor structures, and the method comprises processing the transistor structures in the same tier from separate channel layers.

In an implementation of the method, the transistor structures are forksheet transistor structures and the method comprises: processing two channel layers for the transistor structures in a same tier of the SRAM cell; processing a dielectric wall in between the channel layers; and processing one or two gate structures around the channel layers to form the respective transistor structures of the same tier.

According to the above aspects and implementations, this disclosure proposes an SRAM cell design using hybrid CFET technology. The word "hybrid" indicates that the active region, that is the lateral extension of both first and second channel layers, was formed using a so called monolithic CFET scheme, using one-side processing whereas the rest of the process followed a so called sequential scheme using dual-side processing. For example, gate structures and metal layers for the interconnect structure may be formed on one side of the stack, and subsequently (e.g., after flipping the stack) gate structures and metal layers for the interconnect structure may be formed on the other side of the stack. Using CFET integration techniques can provide a large cell area reduction, for instance, compared to conventional nanosheet and forksheet based SRAM cells. Furthermore, the dual-side processing of the BEOL metal layers also allows relaxing the metal widths and shortening via connections for both word line and bit line(s). Thus, the resistance of the bit line(s) and word line and the capacitance of the vias for connecting bit line(s) and word line can be lowered. As a result, the performance of the SRAM cell can be improved.

### BRIEF DESCRIPTION OF THE DRAWINGS

The above-described aspects and implementations are explained in the following description of exemplary embodiments with respect to the drawings, wherein:
- FIG. 1: shows a one-tier stacked SRAM cell according to an exemplary embodiment of this disclosure in (a) a top view and (b) cross-sectional views.
- FIG. 2: shows in a three-tier stacked SRAM cell according to an exemplary embodiment of this disclosure in (a) a bottom/top view and (b) cross-sectional views.
- FIG. 3: shows a six-tier stacked SRAM cell according to an exemplary embodiment of this disclosure in a cross-sectional view.
- FIG. 4: shows a conventional stacked SRAM cell in (a) a bottom view, (b) a top view, and (c) cross-sectional views.
- FIG. 5: shows a two-tier stacked SRAM cell according to an exemplary embodiment of this disclosure in (a) a bottom view, (b) a top view, and (c) cross-sectional views.
- FIG. 6: shows in (a) and (b) two-tier stacked SRAM cells according to two exemplary embodiments of this disclosure in cross-sectional views, respectively.
- FIG. 7: shows a method for fabricating a stacked SRAM cell, according to an embodiment of this disclosure.

### DETAILED DESCRIPTION OF EMBODIMENTS OF THE INVENTION

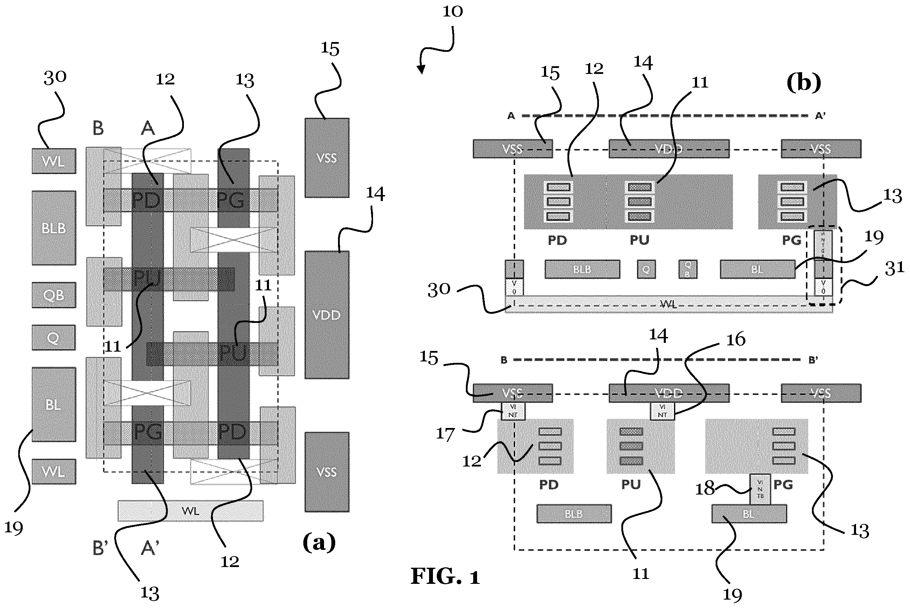

FIG. 1 shows an SRAM cell 10 according to an exemplary embodiment of this disclosure. The SRAM cell 10 has one tier. FIG. 1(a) shows the tier and the interconnect structure in a top view, and FIG. 1(b) shows cross-sectional views of the SRAM cell 10 along the lines A-A and B-B indicated in FIG. 1(a), respectively. The SRAM cell 10 of FIG. 1 comprises a plurality of transistor structures, which are arranged in the same single tier of the SRAM cell 10. Thus, the SRAM cell 10 is called a one-tier stacked SRAM cell 10.

In particular, the SRAM cell 10 of FIG. 1 comprises two first transistor structures 11, and two second transistor structures 12. The first transistor structures 11 may be PMOS and/or PU transistor structures, and the second transistor structures 12 may be NMOS and/or PD transistor structures, or this may be vice versa. The first transistor structures 11 and the second transistor structures 12 form a pair of cross-coupled inverters, and are configured to store a bit of data, like a conventional SRAM cell.

The SRAM cell 10 of FIG. 1 further comprises one or two PG transistor structures 13. As an example, two PG transistor structures 13 are shown in FIG. 1(a). The at least one PG transistor structure 13 is, in the one-tier stacked SRAM cell 10, typically processed similarly to the second transistor structures 12, i.e., it is PMOS or NMOS according to what the second transistor structures 12 are.

The SRAM cell 10 of FIG. 1 further comprises at least one first power rail 14 and at least one second power rail 15, which are arranged above the transistor structures 11, 12, 13, i.e., above the single tier of the SRAM cell 10 (see FIG. 1(b)). The at least one first power rail 14 is connected by respective first vias 16 to the first transistor structures 11 from above, and the at least one second power rail 15 is connected by respective second vias 17 to the second transistor structures 12 from above (see FIG. 1(b), the lower part). The SRAM cell 10 may comprise more than one first power rail 14 and/or may comprise more than one second power rail 15.

The SRAM cell 10 of FIG. 1 also comprises a bit line 19, which is arranged below the transistor structures 11, 12, 13. The bit line 19 is connected by a third via 18 to the PG transistor structure 13 from below (see FIG. 1(b), the lower part). The SRAM cell 10 may comprise two bit lines 19, in particular, since the SRAM cell 10 of FIG. 1 exemplarily comprises two PG transistor structures 13. Each bit line 19 may be connected to one of the two PG transistor structures 13. The SRAM cell 10 may also comprise a word line 30 arranged below the transistor structures 11, 12, 13 (see FIG. 1(b), the upper part), which may be connected by a fourth via 31 (which may consist of two or more via parts and at least one metal layer) to the PG transistor structure 13 from below.

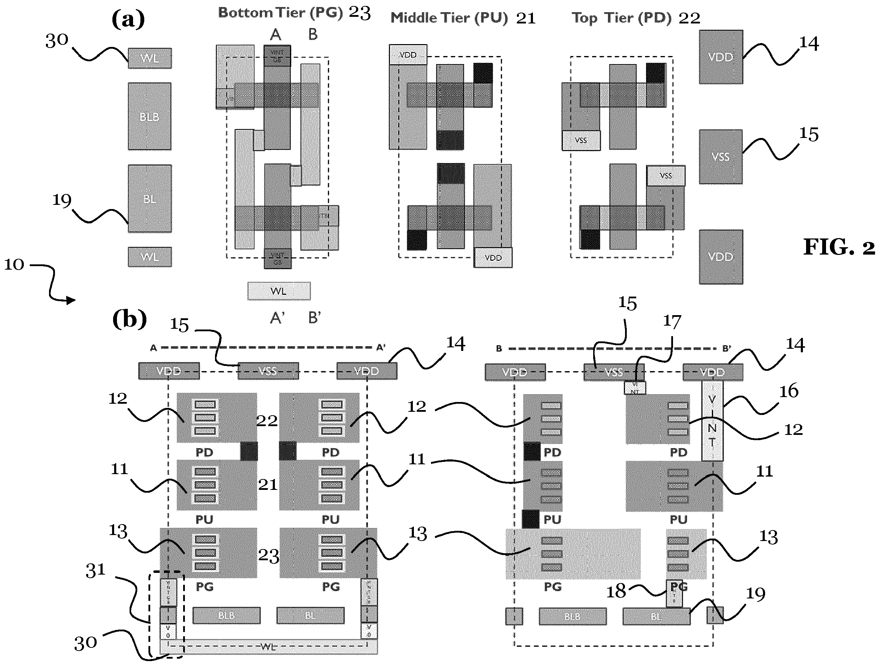

FIG. 2 shows an SRAM cell 10 according to another exemplary embodiment of this disclosure. The SRAM cell 10 has three tiers. FIG. 2(a) shows the three tiers and the respective interconnect structures in a bottom/top view, and FIG. 2(b) shows cross-sectional views of the SRAM cell 10 along the lines A-A and B-B indicated in FIG. 2(a), respectively. The SRAM cell 10 of FIG. 2 comprises a plurality of transistor structures, which are arranged in three tiers 21, 22, and 23 of the SRAM cell 10. The SRAM cell 10 is thus called a three-tier stacked SRAM cell 10.

In particular, the SRAM cell 10 of FIG. 2 comprises two first transistor structures 11 formed in a first tier 21, and two second transistor structures 12 formed in a second tier 22. The second tier 22 is arranged above the first tier 21. Notably, the two first transistor structures 11 and the two second transistor structures 12 may be distributed in different manner over the first tier 21 and the second tier 22. For instance, the first transistor structures 11 may be both in the second tier 22, and the second transistor structures 12 may be both in the first tier 21.

Further, the SRAM cell 10 of FIG. 2 comprises two PG structures 13 formed in a third tier 23, the third tier 23 being arranged below the first tier 21. One or two of the PG transistor structures 13 could also be formed in the first tier 21. The SRAM cell 10 could also include only one PG transistor structure 13, which may either be in the third tier 23 or in the first tier 21. Accordingly, while the SRAM cell 10 of FIG. 2 is illustrated as a three-tier stacked SRAM cell 10, it could similarly be a two-tier stacked SRAM cell 10 without the third tier 23. The at least one PG transistor structure 13 is, in the two-tier stacked SRAM cell 10 typically processed similarly to the transistor structures formed in the first tier 21, i.e., it is PMOS or NMOS according to what the transistor structures in the first tier 21 are. In the three-tier stacked SRAM cell 10, the at least one PG transistor structure 13 can be either NMOS or PMOS without consideration of the first or second transistor structures 11, 12.

The SRAM of FIG. 2 also comprises at least one first power rail 14 and at least one second power rail 15, which are arranged above the second tier 22. The first power rail 14 is connected by respective first vias 16 to the first transistor structures 11 in the first tier 21 from above, and the second power rail 15 is connected by respective second vias 17 to the second transistor structures 12 in the second tier 22 from above (see FIG. 2(b), the right side).

The SRAM cell 10 of FIG. 2 further comprises two bit lines 19, which are arranged below the third tier 23. The two bit lines 19 are respectively connected by respective third vias 18 to the two PG transistor structures 13 (see FIG. 2(b), the right side). It can be derived from FIG. 2 that a length of each third via 18 may be smaller than a height of the second tier 22, unlike in a conventional stacked SRAM cell. The SRAM cell 10 of FIG. 2 may also comprise a word line 30 arranged below the third tier 23 (see Fig. 2(b) left side), which may be connected by respective fourth vias 31 (which may consist of two or more via parts and at least one metal layer) to the PG transistor structures 13 from below.

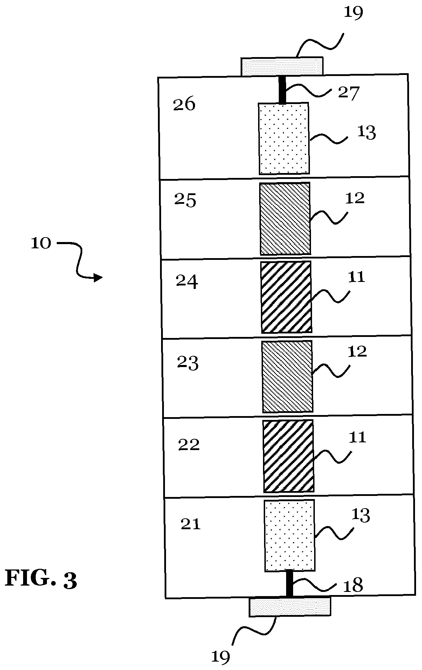

FIG. 3 shows a stacked SRAM cell 10 according to another embodiment of this disclosure. The SRAM cell 10 of FIG. 3 comprises a plurality of transistor structures, which are arranged in six tiers 21, 22, 23, 24, 25, and 26, of the SRAM cell 10. The SRAM cell 10 is thus called a six-tier stacked SRAM cell.

The SRAM cell 10 of FIG. 3 comprises a first PG transistor structure 13 formed in a first tier 21, and a second PG transistor structure 13 formed in a sixth tier 26, the sixth tier 26 being arranged above all the other tiers.

The SRAM cell 10 of FIG. 3 further comprises two first transistor structures 11 and two second transistor structures 12 formed, respectively, in a second tier 22, a third tier 23, a fourth tier 24, and a fifth tier 25, wherein the second tier 22 is arranged above the first tier 21, the third tier 23 is arranged above the second tier 22, the fourth tier 24 is arranged above the third tier 23, and the fifth tier 25 is arranged above the fourth tier 24. Specifically in FIG. 3, a first transistor structure 11 is formed in the second tier 22, a second transistor structure 12 is formed in the third tier 23, a first transistor structure 11 is formed in the fourth tier 24, and a second transistor structure 12 is formed in the fifth tier 25. Accordingly, the first and second transistor structures 11, 12 are stacked in an interleaved manner. However, the first and second transistor structures 11, 12 may be distributed in any other way among the second to fifth tiers 22-25, for instance, the first transistor structures 11 could be formed in the second and the third tier 22, 23, and the second transistor structures 22 could be formed in the fourth and the fifth tier, 24, 25, or this could be vice versa.

The SRAM cell 10 of FIG. 3 further comprises a first bit line 19, which is arranged below the first tier 21 and is connected by a third via 18 to the first PG transistor structure 13 from below, and comprises a second bit line 19, which is arranged above the sixth tier 26 and is connected by a fifth via 27 to the second PG transistor structure 13 from above. It can be derived from FIG. 3 that a length of the third via 18 and the fifth via 27 may be smaller than a height of each tier, unlike in a conventional stacked SRAM cell. The SRAM cell 10 of FIG. 3 may also comprise the word line 30 arranged below the first tier 21 (not shown here), which may be connected by a fourth via 31 to the first PG transistor structure 13 from below. The SRAM cell 10 may comprise a word line 30 arranged above the sixth tier 26, which may be connected by a via to the second PG transistor structure 13 from above.

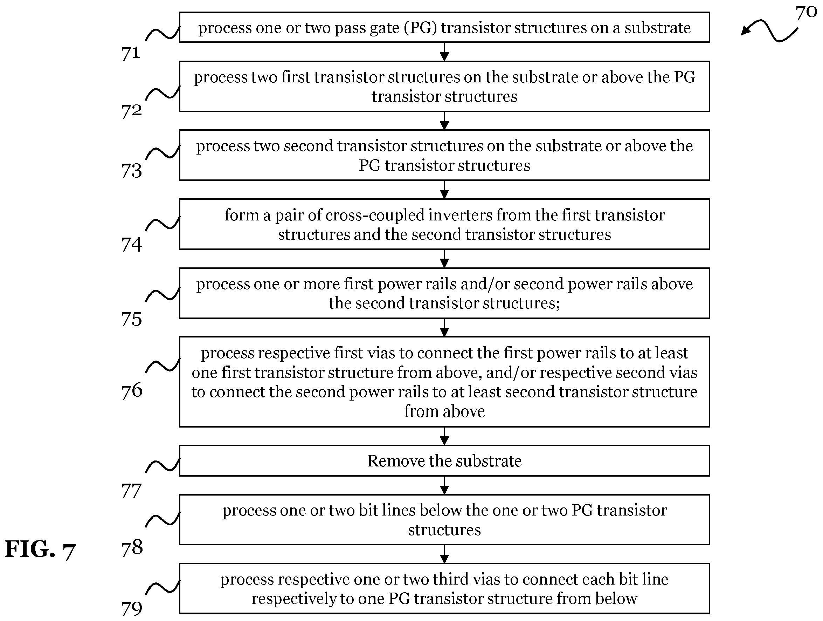

The SRAM cells 10 of FIG. 1, FIG. 2 and FIG. 3 can be fabricated with a method 70 for processing a stacked SRAM cell 10 according to an embodiment of this disclosure, wherein the method 70 is shown as flow-diagram in FIG. 7.

The method 70 comprises a step 71 of processing one or two PG transistor structures 13 on a substrate, and a step 72 of processing two first transistor structures 11 on the substrate or above the PG transistor structures 13. If the first transistor structures 11 are processed on the substrate next to the PG transistor structures 13, an SRAM cell 10 of FIG. 1 can be obtained. If the first transistor structures 11 are processed above the PG transistor structures 13, an SRAM cell 10 of FIG. 2 or of FIG. 3 can be obtained. For the SRAM cell 10 of FIG. 2, the two first transistor structures 11 are processed in the same tier. For the SRAM cell 10 of FIG. 3, the two first transistor structures 11 are processed in different tiers.

The method 70 further comprises a step 73 of processing two second transistor structures 12 on the substrate or above the PG transistor structures 13. If the second transistor structures 12 are processed on the substrate next to the PG transistor structures 13 (and next to the first transistor structures 11), an SRAM cell 10 of FIG. 1 can be obtained. If the second transistor structures 12 are processed above the PG transistor structures 13, an SRAM cell 10 of FIG. 2 or of FIG. 3 can be obtained. For the SRAM cell 10 of FIG. 2, the two second transistor structures 12 are processed in the same tier. For the SRAM cell 10 of FIG. 3, the two second transistor structures 11 are processed in different tiers.

The method 70 further comprises a step 74 of forming a pair of cross-coupled inverters from the first transistor structures 11 and the second transistor structures 12.

The method 70 further comprises a step 75 of processing one or more first power rails 14 and/or one or more second power rails 15 above the second transistor structures 12. Further, a step 76 of processing respective first vias 16 to connect the one or more first power rails 14 to at least one of the first transistor structures 11 from above, and/or of processing respective second vias 17 to connect the one or more second power rails 15 to at least one of the second transistor structures 11 from above. These steps 75 and 76 may be performed by processing a front-side of the stack. BEOL processing tools may be used.

Then, the method 70 comprises a step 77 of removing the substrate. This may be done by thinning the substrate from the backside of the stack.

Further, the method 70 comprises a step 78 of processing one or two bit lines 19 below the one or two PG transistor structures 13, and a step 78 of processing respective one or two third vias 18 to connect each bit line 19, respectively, to one PG transistor structure 13 from below. These steps 78 and 79 may be performed by processing the back-side of the stack as the front-side of the stack, for instance, by turning the stack. BEOL processing tools may be used.

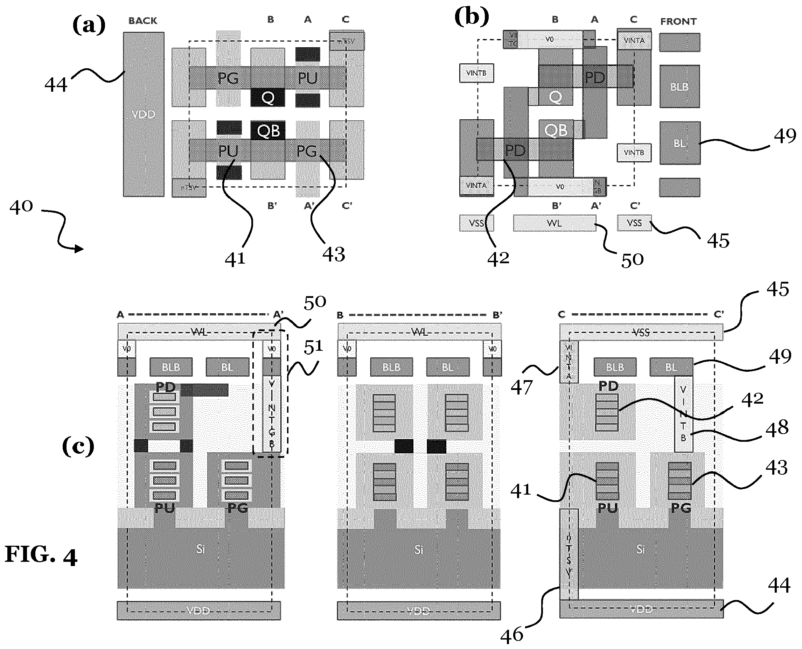

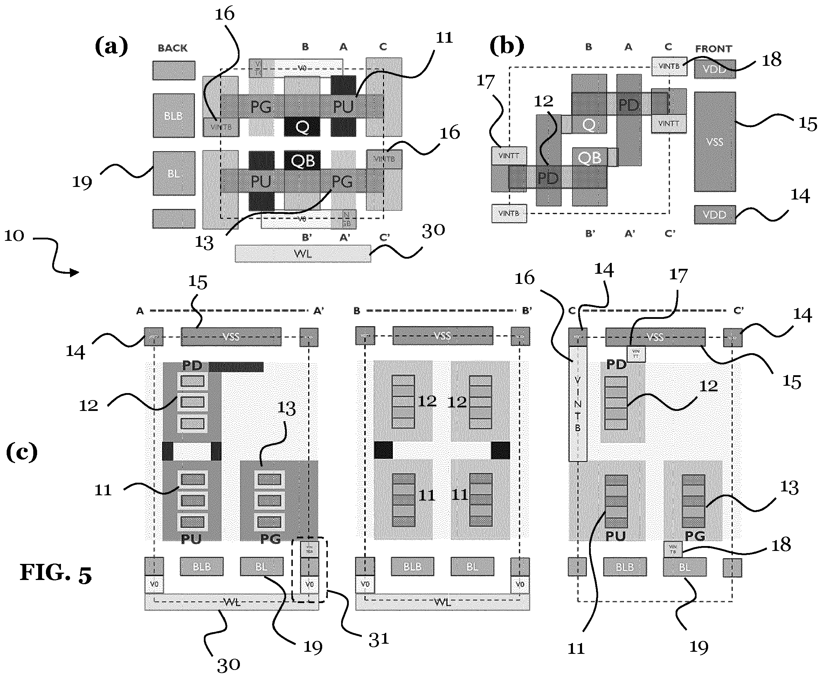

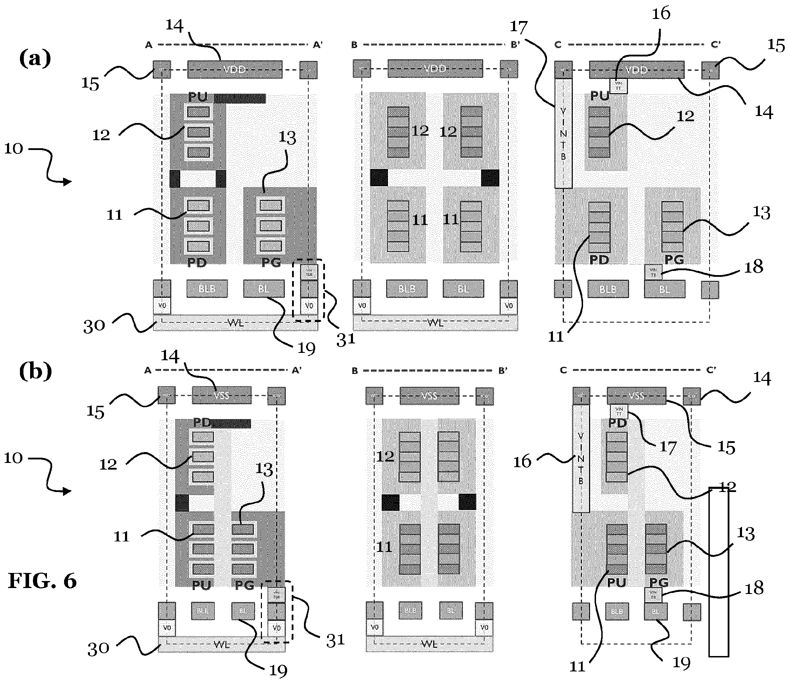

The advantages of the SRAM cells 10 of FIG. 1, FIG. 2, and FIG. 3, and accordingly of the method 70, when compared to a conventional stacked SRAM cell, include the lower via capacitances and the lower bit line and word line resistances. The differences will be further explained with respect to a comparison between two-tier stacked SRAM cells 10 according to further exemplary embodiments of this disclosure, which are shown in FIG. 5 and FIG. 6, and a conventional two-tier stacked SRAM cell 40 shown in FIG. 4.

FIG. 4(a) shows a bottom view of the conventional SRAM cell 40, i.e., a bottom tier and a bottom-side interconnect structure. FIG. 4(b) shows a top view of the SRAM cell 40, i.e., a top tier and a top-side interconnect structure. FIG. 4(c) show cross-sectional views of the SRAM cell 40 along the lines A-A, B-B, and C-C indicated in FIG. 4(a), respectively.

In particular, FIG. 4 shows a high-density nanosheet FET based 6T SRAM cell 40 that is sequentially stacked. In particular, as indicated in FIG. 4(c), the SRAM cell 40 comprises two first (PU) transistor structures 41, two second (PD) transistor structures 42, two PG transistor structures 43, a first power rail 44, second power rail 45, and at least one bit line 49. The first power rail 44 is connected by a via 46 to the PU transistor structures 41, the second power rail 45 is connected by a via 47 to the PD transistor structures 42, and the bit line 49 is connected by a via 48 from above to the PG transistor structure 43. Further, a word line 50 is connected by a via 51 (may consist of two or more via parts and at least one metal layer) to the PG transistor structure 43 from above.

It can be derived from FIG. 4 that all vias, particularly the vias 48 and 51, are relatively long. Thus, a via capacitance may occupy a large percentage of the total BEOL capacitance. The SRAM cells 10 in FIG. 5 and FIG. 6 address this issue, and have specifically designed interconnect structures that may achieve shorter vias, and thus a reduced BEOL capacitance.

FIG. 5 shows an SRAM cell 10 according to an exemplary embodiment of this disclosure. The SRAM cell 10 has two tiers. FIG. 5(a) shows the bottom tier and a bottom-side interconnect structure, FIG. 5(b) shows the top tier and a top-side interconnect structure, and FIG. 5(c) shows cross-sectional views of the SRAM cell 10 along the lines A-A, B-B, and C-C indicated in FIG. 5(a), respectively.

The first transistor structures 11 of the SRAM cell 10 of FIG. 5 are PMOS PU transistor structures, the second transistor structures 12 are NMOS PD transistor structures, and the PG transistor structures 13 are PMOS transistor structures. All transistor structures are nanosheet transistor structures.

One or more first power rails 14 are configured to provide a supply voltage (VDD), and one or more second power rails 15 are configured to provide a ground voltage (VSS).

It can be seen in FIG. 5 that dual-side "metal intermediate (Mint)" structures can be processed, i.e., metal layers of the BEOL can be processed on both sides of the transistor structures 11, 12, 13. The word line 30 and the bit line 19 can be placed on the bottom side of the SRAM cell 10, i.e., below the transistor structures 11, 12, 13, while the power rails 14, 15, can be placed on the top side of the SRAM cell 10, i.e., above the transistor structures 11, 12, 13. FIG. 5(c) shows that thus the third via 18 connecting the bit line 19 to one of the PG transistor structures 13 is quite short, at least shorter than the via 48 shown in FIG. 4(c). Also the fourth via 31 connecting the word line 30 to the PG transistor structure 13 is quite short, at least shorter than the via 51 shown in FIG. 4(c).

FIG. 6(a) shows an SRAM cell 10 according to another exemplary embodiment of this disclosure. The SRAM cell 10 has two tiers. FIG. 6(a) shows cross-sectional views of the SRAM cell 10. The bottom view and top view of this SRAM cell 10 are similar than for the SRAM cell 10 in FIG. 5(a) and (b). The cross-sectional views in FIG. 6(a) are thus along similar lines A-A, B-B, and C-C as indicated in FIG. 5(a), respectively.

The first transistor structures 11 of the SRAM cell 10 of FIG. 6(a) are NMOS PD transistor structures, the second transistor structures 12 are PMOS PD transistor structures, and the PG transistor structures 13 are NMOS transistor structures.

One or more second power rails 15 are configured to provide a supply voltage (VDD), and one or more first power rails 14 are configured to provide a ground voltage (VSS).

The SRAM cell 10 of FIG. 6(a) is similar to that of FIG. 5, only NMOS and PMOS, and accordingly PU and PD, and also VSS and VDD, are swapped. All transistor structures are again nanosheet transistor structures, like in FIG. 5. For fabricating the SRAM cell 10, for instance, with the method 70, those transistor structures 11, 12, 13 that are in the same tier, are respectively processed from separate channel layers.

FIG. 6(b) shows an SRAM cell 10 according to another exemplary embodiment of this disclosure. The SRAM cell 10 has two tiers. FIG. 6(b) shows cross-sectional views of the SRAM cell 10. The bottom view and top view of this SRAM cell 10 are similar than for the SRAM cell 10 in FIG. 5(a) and (b). The cross-sectional views in FIG. 6(b) are thus along similar lines A-A, B-B, and C-C similar as indicated in FIG. 5(a), respectively.

The first transistor structures 11 of the SRAM cell 10 of FIG. 6(a) are PMOS PU transistor structures, the second transistor structures 12 are NMOS PD transistor structures, and the PG transistor structures 13 are PMOS transistor structures.

One or more first power rails 14 are configured to provide a supply voltage (VDD), and one or more second power rails 15 are configured to provide a ground voltage (VSS).

The SRAM cell 10 of FIG. 6(b) is similar to that of FIG. 5, only now all the transistor structures 11, 12, 13 are forksheet transistor structures instead of nanosheet transistor structures in FIG. 5. For fabricating the SRAM cell 10 of FIG. 6(b), for instance, with the method 70, two channel layers are processed for those transistor structures 11, 12, 13 that are in a same tier. Then a dielectric wall is processed in between these channel layers, and then one or two gate structures are processed around these channel layers to form the respective transistor structures 11, 12, 13 of that tier.

For both SRAM cells 10 of FIG. 6, metal layers of the BEOL can be processed on both sides of the transistor structures 11, 12, 13. The word line 30 and the bit line 19 can again be placed on the bottom side of the SRAM cell 10, and the power rails 14, 15 can be placed on the top side of the SRAM cell 10. The third vias 18 connecting the bit lines 19 to the PG transistor structures 13, and the fourth vias 31 connecting the word lines 30 to the PG transistor structures 13, can thus be made short.

In addition, for all the SRAM cells 10 according to embodiments of this disclosure, the word line 30 may become wider than in the conventional SRAM cell 40 of FIG. 4, which may lead to a smaller word line resistances. The same may be true for the one or two bit lines 19. This resistance decrease can be achieved, because the dual-side Mint interconnect structure processing is enabled by the method 70. Furthermore, by placing the word line 30 and the bit line 19 closer to the bottom PG transistor structures 13 than in the conventional SRAM cell 40 of FIG. 4, shorter vias 18 and 31 for the bit line 19 and the word line 30, respectively, are possible. As a result, the bit line and word line capacitances can be reduced, and the performance and energy consumption of the stacked SRAM cells 10 of this disclosure may be improved compared to the conventional stacked SRAM cell 40.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A stacked static random access memory, SRAM, cell (10) comprising:
two first transistor structures (11);
two second transistor structures (12);
wherein the first transistor structures (11) and the second transistor structures (12) form a pair of cross-coupled inverters;
one or two pass gate, PG, transistor structures (13);
one or more first power rails (14) and/or one or more second power rails (15) arranged above the first and the second transistor structures (11, 12), wherein the one or more first power rails (14) are connected by respective first vias (16) to at least one of the first transistor structures (11) from above, and/or the one or more second power rails (15) are connected by respective second vias (17) to at least one of the second transistor structures (12) from above; and
one or two bit lines (19) arranged below the PG transistor structures (13), wherein each bit line (19) is connected by a respective third via (18) to one PG transistor structure (13) from below.

2. The stacked SRAM cell (10) according to claim 1, further comprising:
a word line (30) arranged below the PG transistor structures (13), wherein the word line (30) is connected by one or two respective fourth vias (31) to the one or two PG transistor structures (13) from below.

3. The stacked SRAM cell (10) according to claim 1 or 2, comprising a plurality of stacked tiers (21, 22, 23, 24, 25, 26), wherein at least one of the first, the second, or the PG transistor structures (11, 12, 13) is formed in each of the tiers (21, 22, 23, 24, 25, 26).

4. The stacked SRAM cell (10) according to one of the claims 1 to 3, wherein:
the first transistor structures (11) are formed in a first tier (21) of the SRAM cell (10);
the second transistor structures (12) are formed in a second tier (22) of the SRAM cell (10), the second tier (22) being arranged above the first tier (21);
the one or two PG structures (13) are formed in the first tier (21) or in a third tier (23) of the SRAM cell (10), the third tier (23) being arranged below the first tier (21); and
the first and the second power rails (14, 15) are arranged above the second tier (22), wherein the first power rails (14) are connected by respective first vias (16) to the first transistor structures (11) from above, and the second power rails (15) are connected by respective second vias (17) to the second transistor structures (12) from above.

5. The stacked SRAM cell (10) according to claim 4, wherein:
a length of each third via (18) is smaller than a height of the second tier (22); and/or
a length of each fourth via (41) is smaller than a height of the second tier (22).

6. The stacked SRAM cell (10) according to one of the claims 1 to 3, wherein:
a first PG transistor structure (13) is formed in a first tier (21) of the SRAM cell (10);
the two first transistor structures (11) and the two second transistor structures (12) are formed, respectively, in a second tier (22), a third tier (23), a fourth tier (24), and a fifth tier (25) of the SRAM cell (10), the second tier (22) being arranged above the first tier (21), the third tier (23) being arranged above the second tier (22), the fourth tier (24) being arranged above the third tier (23), and the fifth tier (25) being arranged above the fourth tier (24);
a second PG transistor structure (13) is formed in a sixth tier (26) of the SRAM cell (10), the sixth tier (26) being arranged above the fifth tier (25);
a first bit line (19) is arranged below the first tier (21) and is connected by one third via (18) to the first PG transistor structure (13) from below; and
a second bit line (19) is arranged above the sixth tier (26) and is connected by a fifth via (27) to the second PG transistor structure (13) from above.

7. The stacked SRAM cell (10) according to one of the claims 1 to 6, wherein the transistor structures (11, 12, 13) are nanosheet transistor structures, or forksheet transistor structures, or fin transistor structures.

8. The stacked SRAM cell (10) according to one of the claims 1 to 7, wherein:
the first transistor structures (11) and the one or two PG transistor structures (13) are PMOS transistor structures, and the second transistor (12) structures are NMOS transistor structures; and/or
the first transistor structures (11) are pull-up, PU, transistor structures, and the second transistor structures (12) are pull-down, PD, transistor structures of the SRAM cell (10); and
wherein the one or more first power rails (14) are configured to provide a supply voltage (VDD), and the one or more second power rails (15) are configured to provide a ground voltage (VSS).

9. The stacked SRAM cell (10) according to one of the claims 1 to 7, wherein:
the first transistor structures (11) and the one or two PG transistor structures (13) are NMOS transistor structures, and the second transistor structures (12) are PMOS transistor structures; and/or
the first transistor structures (11) are PD transistor structures, and the second transistor structures (12) are PU transistor structures; and
wherein the one or more first power rails (14) are configured to provide a ground voltage (VSS), and the one or more second power rails (15) are configured to provide a supply voltage (VDD).

10. A method (70) for processing a stacked static random access memory, SRAM, cell (10), the method (70) comprising:
processing (71) one or two pass gate, PG, transistor structures (13) on a substrate;
processing (72) two first transistor structures (11) on the substrate or above the PG transistor structures (13);
processing (73) two second transistor structures (12) on the substrate or above the PG transistor structures (13);
forming (74) a pair of cross-coupled inverters from the first transistor structures (11) and the second transistor structures (12);
processing (75) one or more first power rails (14) and/or one or more second power rails (15) above the second transistor structures (12);
processing (76) respective first vias (16) to connect the one or more first power rails (14) to at least one of the first transistor structures (11) from above, and/or respective second vias (17) to connect the one or more second power rails (15) to at least one of the second transistor structures (12) from above;
removing (77) the substrate;
processing (78) one or two bit lines (19) below the one or two PG transistor structures (13); and
processing (79) respective one or two third vias (18) to connect each bit line (19) respectively to one PG transistor structure (13) from below.

11. The method (70) according to claim 10, wherein:
the first transistor structures (11) are processed from first channel layers, and the second transistor structures (12) are processed from second channel layers; and
wherein the second channel layers are stacked above the first channel layers and/or at least one of the first channel layers and the second channel layers is formed on the substrate.

12. The method (70) according to claim 10 or 11, wherein removing (77) the substrate comprises thinning the substrate from the backside, to expose the channel layers formed on the substrate.

13. The method (70) according to one of the claims 10 to 12, wherein the transistor structures (11, 12, 13) are nanosheet transistor structures or fin transistor structures, and the method (70) comprises:
processing the transistor structures (11, 12, 13) that are in the same tier (21, 22) of the SRAM cell (10) from separate channel layers.

14. The method (70) according to one of the claims 10 to 13, wherein the transistor structures (11, 12, 13) are forksheet transistor structures and the method (70) comprises:
processing two channel layers for the transistor structures (11, 12, 13) that are in a same tier (21, 22) of the SRAM cell (10);
processing a dielectric wall in between the channel layers; and
processing one or two gate structures around the channel layers to form the respective transistor structures (11, 12, 13) of the same tier (21, 22).
